(19) Europäisches Patentamt

European Patent Office

Office européen des brevets

(11) **EP 0 982 866 B1**

(12) **FASCICULE DE BREVET EUROPEEN**

(45) Date de publication et mention
de la délivrance du brevet:
**27.08.2003   Bulletin 2003/35**

(51) Int Cl.⁷: **H03M 13/23**

(21) Numéro de dépôt: **99401853.9**

(22) Date de dépôt: **22.07.1999**

(54) **Procédé de codage convolutif et de transmission par paquets d'un flux série de données numériques, procédé et dispositif de décodage correspondants**

Verfahren zur Faltungskodierung und Uebertragung von digitalen Datenpaketen, Gerät und Verfahren zur entsprechenden Dekodierung

Method for convolutional coding and transmission of a stream of packets of digital data, and a method and apparatus for corresponding decoding

(84) Etats contractants désignés:
**DE FI GB IT NL SE**

(30) Priorité: **28.07.1998 FR 9809636**

(43) Date de publication de la demande:
**01.03.2000   Bulletin 2000/09**

(73) Titulaire: **ATMEL NANTES SA**
**44300 Nantes (FR)**

(72) Inventeurs:
• **Mantelet, Guy**
**44240 Suce sur Erdre (FR)**

• **Burban, Anne**
**44300 Nantes (FR)**

(74) Mandataire: **Fréchède, Michel**
**Cabinet Plasseraud**
**84, rue d'Amsterdam**
**F-75440 Paris Cédex 09 (FR)**

(56) Documents cités:
**GB-A- 2 253 974**     **US-A- 4 554 656**
**US-A- 5 355 522**

Printed by Jouve, 75001 PARIS (FR)

**Description**

L'invention concerne un procédé de codage convolutif et de transmission par paquets d'un flux série de données numériques, le procédé et le dispositif de décodage correspondants.

Le domaine technique relatif à la transmission de données numériques, notamment par voie hertzienne ou satellitaire a vu son intérêt prendre une importance grandissante, dans la dernière décennie.

Une contrainte essentielle, lors de la transmission de ces données, est la conservation de l'intégrité de ces données et en définitive de l'intelligibilité de l'information véhiculée par celles-ci. En effet, dans le cas où des perturbations physiques, notamment radioélectriques, interviennent, le message transmis est corrompu et peut devenir inexploitable.

Afin de se prémunir vis-à-vis de tels risques, de nombreuses applications mettant en oeuvre un processus de transmission de données numériques, transmission audio et/ou vidéo par télédiffusion terrestre ou satellitaire, font appel à des processus de codage des données transmises, et notamment de codage convolutif.

Les processus de codage convolutif représentent une classe de processus de codage correcteurs d'erreurs performants, lesquels peuvent être appliqués à des opérations de transmission série de données, dans un canal de transmission perturbé par un bruit de type Gaussien, tel que le canal de transmission par liaison hertzienne entre une station terrestre et une station satellitaire.

D'une manière générale, pour coder un message avec un code de type convolutionnel, on utilise, non seulement la donnée courante présente à l'instant t en entrée du codeur, bit courant de rang k, mais également les n données ou bits de rang précédent. On introduit ainsi un effet de mémoire d'ordre n pour coder cette donnée. En référence à un tel principe, il apparaît ainsi que tout message transmis tient compte du contenu antérieur du message. Le contenu antérieur du message à l'instant t est mémorisé dans une mémoire réactualisée à chaque bit courant. La taille de cette mémoire est définie par la longueur du contenu antérieur, qui est appelée longueur de contrainte du code utilisé (ou "*profondeur de codage*" ci-après) et désignée par K, avec K = n+1.

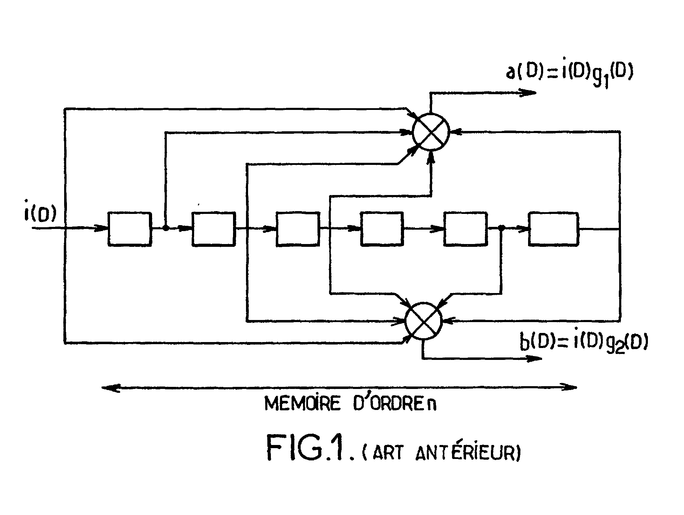

En référence à la figure 1, relative à un dispositif de codage convolutif connu de l'art antérieur, une mémoire formée par exemple par un registre à décalage muni de cellules élémentaires permettant de mémoriser n bits successifs, le bit antérieur au bit courant $i(D-1)$ jusqu'au bit $i(D-n)$ de rang D-n, permet ensuite un traitement logique, par un opérateur logique de type OU exclusif par exemple, du bit courant $i(D)$ par plusieurs bits antérieurs de rang déterminé. De manière usuelle et afin de renforcer la protection contre les erreurs, il est opportun d'engendrer deux ou plus valeurs codées $a(D)$ et $b(D)$, corrélées entre elles par deux contraintes distinctes. Chaque valeur codée associée $a(D);b(D)$ constitue ainsi un symbole $S(D) = \{a(D);b(D)\}$ représentatif de la donnée courante $i(D)$. Dans l'exemple de la figure 1 donné à titre non limitatif, la profondeur de codage est K = 7. Les valeurs codées successives $a(D)$ et $b(D)$ sont données par les relations :

$$a(D) = i(D)g_1(D) \text{ avec } g_1 = 171 \text{ oct}$$
$$b(D) = i(D)g_2(D) \text{ avec } g_2 = 133 \text{ oct}$$

la notation oct désignant la notation octale.

Ainsi, les processus de codage convolutif précités et les codes correcteurs d'erreur correspondants peuvent-ils être mis en oeuvre grâce à des circuits de structure simple.

Les processus de décodage de tels codes, et en conséquence la correction d'erreurs de transmission, nécessitent par contre la mise en oeuvre de fonctions beaucoup plus complexes.

En particulier, dans le cas d'un codage convolutif, le décodage optimum d'un code ainsi obtenu peut être obtenu grâce à la mise en oeuvre d'un processus de décodage selon l'algorithme de VITERBI. Le principe de l'algorithme précité est basé sur le fait que le codeur correspond en fait à une machine d'état ou automate de structure simple ou présentant à tout le moins un nombre limité d'états.

Selon le principe précité, le récepteur-décodeur, pour déterminer la séquence émise, recherche une estimation à chaque instant de l'état du codeur, lors de la réception de toute nouvelle donnée, c'est-à-dire du bit courant de rang successif.

Un processus universel de décodage d'un tel code consiste alors à comparer la séquence reçue, à l'instant courant, à toutes les séquences possibles qui peuvent être émises et de choisir, parmi celles-ci, celle qui présente un maximum de vraisemblance.

Pour ce faire, on détermine alors la séquence codée a posteriori la plus probable en déterminant l'écart de valeur le plus petit entre la séquence reçue et les séquences codées possibles, la notion d'écart étant définie selon la notion de distance de Hamming.

Un diagramme de treillis permet de visualiser les évolutions, en fonction du temps, de l'état du codeur, pour la valeur de la donnée d'entrée bit de rang k, chaque noeud du treillis représentant un état possible du codeur et de la valeur codée. Pour chaque nouvelle valeur reçue, on calcule alors la distance de Hamming en chaque point du treillis. Cette distance est accumulée à la valeur calculée en ce même point lors de l'évaluation pour la valeur précédente. Déterminer la séquence la plus probable consiste alors à remonter dans le diagramme en treillis en recherchant les valeurs décodées qui correspondent globalement à la plus petite distance de Hamming accumulée.

Pour une description plus complète de l'algorithme de VITERBI, on pourra utilement se reporter à l'article intitulé *The Viterbi Algorithm* publié par G.DAVID FORNEY, Jr., Proceedings of the IEEE vol.61, N°3, Mars 1973, pp. 268 à 278.

Le processus de recherche des valeurs décodées qui correspondent globalement à la plus petite distance de Hamming, par remontée dans le diagramme d'une valeur de donnée et de séquence à la valeur de données et de séquence suivante, implique nécessairement un processus de décodage et par corollaire de codage éminemment continus. En d'autres termes, si l'on souhaite procéder au décodage d'une séquence engendrée au moyen d'un codage convolutif, il n'est aucunement envisageable d'interrompre puis de reprendre le codage ou le décodage. Une telle interruption introduisant des discontinuités dans le diagramme de treillis, aurait alors pour effet, en raison d'une telle discontinuité, d'annihiler toute chance de retrouver le chemin pour lequel la distance de Hamming est minimale et en conséquence la séquence la plus probable.

On connaît par GB 2 253 974 un décodeur capable de mener un décodage de viterbi en continu. Néanmoins, ce décodeur n'est pas capable d'opérer sur des signaux issus de codeurs différents.

La présente invention a pour objet de remédier aux inconvénients des procédés de codage/décodage de l'art antérieur par la mise en oeuvre d'un procédé de codage convolutif et de transmission par paquets d'un flux série de données numériques et d'un procédé de décodage d'un flux série de données numériques codées par codage convolutif et transmises par paquets selon ce procédé, en l'absence de toute dégradation du pouvoir correcteur inhérent au processus de décodage au moyen d'un algorithme de VITERBI, réservé au décodage de flux continu de données codées par un codage convolutif.

Un autre objet de la présente invention est la mise en oeuvre d'un procédé de codage convolutif de transmission par paquets d'un flux série de données numériques issues de codeurs distincts, ces données numériques étant donc a priori décorrélées, et d'un procédé de décodage correspondant permettant de conserver le pouvoir correcteur inhérent au processus de codage convolutif et de décodage selon un algorithme de VITERBI, réservé au décodage de flux continu de données codées par un codage convolutif.

Un autre objet de la présente invention est enfin la mise en oeuvre d'un dispositif de décodage d'un flux série de données numériques codées par codage convolutif et transmises par paquets, conformément au procédé de décodage objet de la présente invention.

Le procédé de codage convolutif et de transmission par paquets d'un flux série de données numériques, au sens de l'invention comme défini dans la revendication 1 ci-après.

Le procédé, objet de la présente invention, de décodage d'un flux série de données numériques et transmises par paquets conformément au procédé de codage selon l'invention, est défini dans la revendication 2 ci-après.

Le dispositif de décodage d'un flux série de données numériques codées par codage convolutif et transmises par paquets, objet de la présente invention, est défini dans la revendication 7 ci-après.

Le procédé de codage, le procédé et le dispositif de décodage, objets de la présente invention, seront mieux compris à la lecture de la description et à l'observation des dessins ci-après, dans lesquels, outre la figure 1 relative à l'art antérieur :

- la figure 2a représente un organigramme général du procédé de codage convolutif et de transmission par paquets d'un flux continu de données conforme à l'objet de la présente invention ;
- la figure 2b représente, dans un mode de réalisation non limitatif, la structure de paquets de symboles codés transmis grâce à la mise en oeuvre du procédé de codage tel qu'illustré en figure 2a ;
- la figure 3a représente un organigramme général d'un procédé de décodage de symboles codés et transmis conformément au procédé, objet de la présente invention, illustré en figure 2a ;
- la figure 3b représente de manière illustrative une étape de génération d'un signal logique d'enveloppe permettant la mise en oeuvre du procédé de décodage illustré en figure 3a ;
- la figure 3c représente un diagramme en treillis relatif à un processus de décodage de VITERBI appliqué à des données numériques codées par codage convolutif et transmises en mode paquet, conformément au procédé objet de l'invention ;
- la figure 4a représente, sous forme de schéma synoptique, un dispositif de décodage conforme à l'objet de la présente invention ;
- les figures 4b à 4e représentent différents modes de réalisation particuliers d'un module de traitement logique des symboles codés et du signal logique d'enveloppe, en fonction de la valeur de repos imposée au codage respectivement au décodage et de la valeur logique du signal d'enveloppe à l'état actif ;
- la figure 5 représente un schéma donné à seul titre d'exemple d'un module générateur du signal logique d'enveloppe ;
- la figure 6 représente un chronogramme de signaux appliqués en sortie d'un dispositif de décodage de VITERBI afin de permettre la discrimination par synchronisation de données décodées à partir de symboles codés validés.

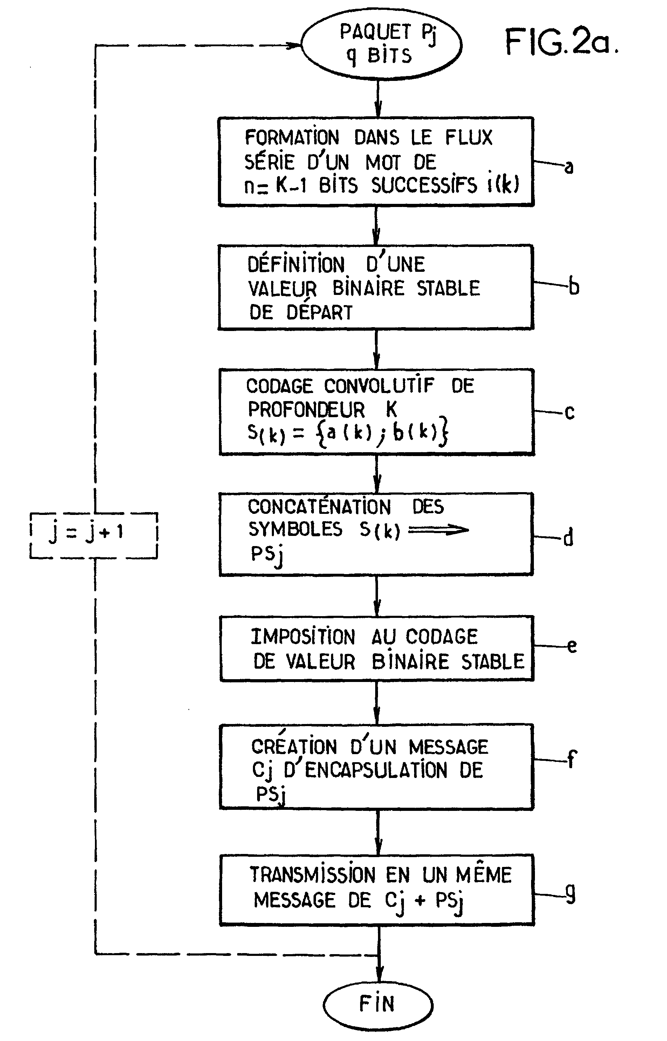

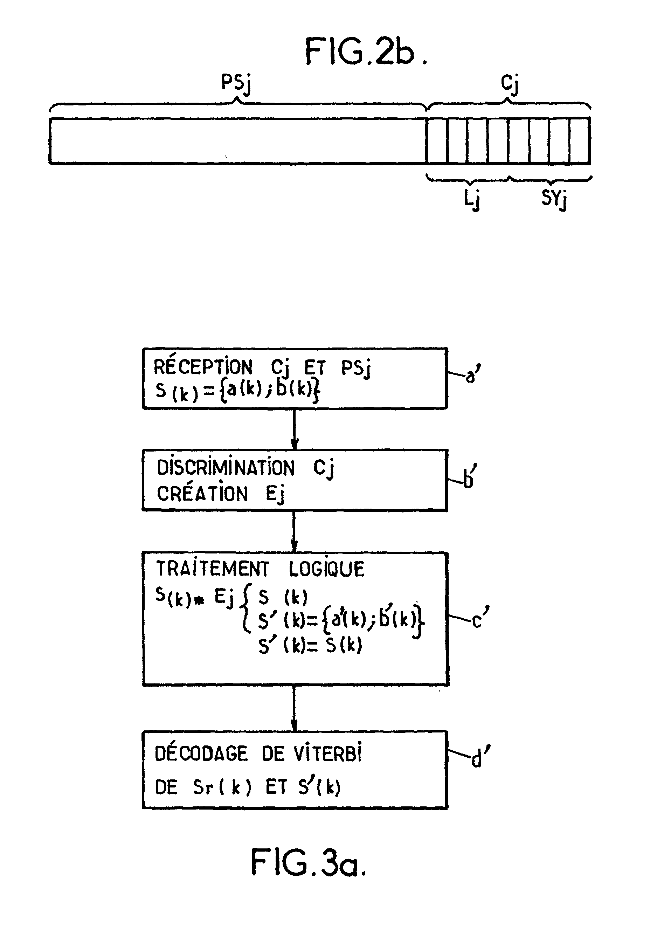

Une description plus détaillée du procédé de codage convolutif et de transmission par paquets d'un flux série de données numériques, conforme à l'objet de la présente invention, sera maintenant donnée en liaison avec les figures 2a et 2b.

D'une manière générale, on indique que chaque paquet de données numériques $P_j$ à coder et à transmettre est constitué par une succession de q bits, i(k), k désignant le rang successif de chacun des bits constitutifs du paquet de données.

D'une manière générale, on indique que le procédé, objet de la présente invention, met en oeuvre un processus de codage convolutif de profondeur K, ainsi que mentionné précédemment dans la description.

Ainsi que représenté sur la figure 2a, le procédé, objet de la présente invention, consiste alors, en une étape a), à discriminer dans le flux série de données, c'est-à-dire pour tout paquet $P_j$ correspondant, un ensemble de n = K-1 bits successifs, n étant bien entendu inférieur à q, pour former un mot courant de n bits.

Le procédé de codage, objet de la présente invention, consiste également, à l'étape b) à définir, pour le processus de codage convolutif précité, une valeur binaire stable, dite de départ, permettant en fait d'initialiser le processus de codage ainsi qu'il sera décrit de manière plus détaillée ci-après dans la description.

En référence à la figure 1, on indique que l'étape a) peut être réalisée par la mise en oeuvre d'une chaîne de cellules mémoires comportant n cellules mémoires destinées à mémoriser l'ensemble de n bits successifs dans le flux série des données et par décalage à chaque bit de rang k du mot de n bits ainsi constitué. On comprend en particulier que la chaîne de cellules mémoires précitée peut avantageusement être réalisée par un registre à décalage, laquelle permet de prélever sur le flux série des données une fenêtre glissante formant le mot de n bits précité.

En ce qui concerne l'étape b) consistant à définir, pour le processus de codage convolutif, une valeur binaire stable de départ, on indique que cette valeur binaire est avantageusement imposée à l'ensemble des cellules mémoires constitutives de la chaîne de cellules mémoires précitée. Ainsi, le processus de codage, conforme à l'objet de la présente invention, consiste en fait à initialiser préalablement à la création du premier mot de n bits dans le paquet $P_j$ précité, le processus de codage convolutif proprement dit par la valeur binaire stable de départ retenue. On comprend ainsi qu'en l'absence de paquet $P_j$, l'ensemble des cellules mémoires constitutives de la chaîne de cellules mémoires est alors positionné à la valeur stable de départ, chaque cellule mémoire présentant la même valeur stable, la valeur 0 ou la valeur 1, ainsi qu'il sera décrit ultérieurement dans la description.

Les étapes a) et b), ainsi que représenté sur la figure 2a, sont alors suivies d'une étape c) consistant à soumettre le mot courant de n bits ainsi formé à un processus de codage convolutif de profondeur K, à chaque valeur de bit i(k) correspondant une première a(k) et une deuxième b(k) valeur codée, ces valeurs codées constituant un symbole codé noté S(k) = {a(k);b(k)}, ce symbole étant représentatif du bit i(k) considéré.

Les symboles S(k) peuvent être obtenus de manière avantageuse à partir d'un processus de codage tel que représenté en figure 1 par exemple. On indique en particulier que le processus de codage est ainsi mis en oeuvre successivement pour l'ensemble des mots de n bits constitutifs du paquet $P_j$ considéré selon le processus indiqué précédemment dans la description.

A l'étape c) est alors associée une étape d) consistant à former, à partir des symboles codés, le nombre de symboles codés étant égal au nombre de bits constitutifs du paquet $P_j$ considéré, un paquet de symboles codés, noté $PS_j$, par concaténation de ces symboles codés. Le processus de concaténation mis en oeuvre consiste à concaténer successivement les valeurs a(k) et b(k) successives, constitutives de chaque symbole codé.

L'étape d) précitée est elle-même suivie d'une étape e) consistant à imposer au processus de codage convolutif la valeur stable, dite de départ, précitée. Dans ces conditions, on comprend que la valeur stable réappliquée au processus de codage permet en fait d'appliquer cette valeur stable non seulement comme valeur de départ pour tout paquet de données ultérieur $P_{j+1}$ susceptible d'être soumis au processus de codage et de transmission par paquets à un instant quelconque, mais également comme valeur de contrainte au processus de codage afin de purger la valeur mémorisée dans chaque cellule mémoire dès la fin du processus de codage du paquet de données courant Pj, conformément au procédé objet de la présente invention.

A partir de l'obtention du paquet de symboles codés $PS_j$ à l'étape d), et bien entendu de l'imposition au codage de la valeur stable de départ à l'étape e), le procédé de codage selon l'invention consiste ensuite à engendrer au moins un message d'encapsulation du paquet de symboles codés. Ce message d'encapsulation, noté $C_j$, peut consister, ainsi qu'il sera décrit ci-après dans la description, en un mot de synchronisation $SY_j$ et une valeur de longueur $L_j$ du paquet de symboles $PS_j$ considéré.

Le message d'encapsulation $C_j$ ayant été créé, le procédé, objet de la présente invention, consiste ensuite à transmettre, en un même message, le message d'encapsulation $C_j$ précité et le paquet de symboles codés $PS_j$, ainsi que représenté à l'étape g) de la figure 2a. Cette transmission en un même message peut consister à effectuer une concaténation du message d'encapsulation $C_j$ et du paquet de symboles codés PSj, puis à effectuer la transmission du message résultant ainsi obtenu pour décodage et utilisation. Bien entendu, en l'absence de paquets de données ultérieurs $P_{j+1}$, le procédé de codage convolutif et de transmission par paquets d'un flux série de données numériques conforme à l'objet de la présente invention, aboutit à une étape de fin, représentée sur la figure 2a, alors que, en présence d'un paquet de données numériques ultérieur de rang j+1, les opérations a) à g) précédentes sont répétées pour le paquet précité, devenant paquet courant, constitutif du flux de bits, et en définitive pour tout paquet successif.

Sur la figure 2b, on a représenté un message résultant de la concaténation d'un message d'encapsulation $C_j$ et du paquet de symboles codés $PS_j$. D'une manière classique, on indique que le message d'encapsulation peut consister en un mot de synchronisation $SY_j$ codé sur un champ de 4 octets par exemple et un champ de longueur du paquet de symboles codés $PS_j$, champ de longueur noté $L_j$, lequel peut être codé par exemple sur 24 octets. Bien entendu, dans le message résultant tel que représenté en figure 2b, la longueur du champ correspondant au paquet de symboles codés $PS_j$ correspond à la valeur de longueur des symboles codés contenus dans le champ $L_j$.

Le procédé de codage par convolution et de transmission par paquets d'un flux de données numériques, conforme à l'objet de la présente invention, tel que décrit en liaison avec les figures 2a et 2b, peut être mis en oeuvre pour le codage de paquets transmis de manière asynchrone sur une ligne de transmission, ces paquets pouvant en particulier émaner d'émetteurs distincts et non corrélés.

Dans ces conditions, on comprend que le processus de codage convolutif mis en oeuvre dans le procédé de codage convolutif et de transmission par paquets, conforme à l'objet de la présente invention, démarre en fait pour tout paquet de données $P_J$ avec un codeur convolutif positionné dans l'état stable précédemment mentionné. Dans ces conditions les n éléments mémoires sont positionnés par exemple, soit à la valeur 0, soit à la valeur 1. De même, afin de garantir l'intégralité du traitement d'un paquet, le processus de codage convolutif mis en oeuvre est alors purgé par l'application au processus de codage d'une valeur fixe déterminée. Dans le mode de réalisation le plus simple, cette valeur fixe déterminée permettant de purger le processus de codage consiste à utiliser la valeur stable dite de départ, cette valeur étant ainsi imposée au processus de codage préalablement et postérieurement au codage d'un paquet proprement dit. Dans un mode de réalisation avantageux non limitatif, on indique que lorsque la valeur stable de départ est choisie égale à zéro, les n cellules mémoires étant positionnées à la valeur zéro, de la même manière et conformément à la mise en oeuvre du procédé, objet de la présente invention, il est alors nécessaire d'ajouter au moins n valeurs stables, dites de départ, précitées en fin de paquet afin de purger les n cellules mémoires de la chaîne de cellules mémoires considérée. Il en est de même lorsque la valeur stable choisie a pour valeur 1. Dans un mode de réalisation simplifié, on indique que le procédé, objet de la présente invention, à titre d'exemple non limitatif, peut alors simplement consister à ajouter par concaténation en début et en fin de paquet de données $P_j$, n valeurs stables considérées. Toutefois, dans un tel mode de réalisation, la valeur de longueur codée dans le champ de longueur $L_j$ est, de préférence, la valeur qui correspond à la longueur réelle du paquet de données $P_j$, compte tenu des valeurs stables concaténées en début et en fin de paquet. Un dispositif de codage permettant la création d'un message résultant tel que décrit en liaison avec la figure 2b ne sera pas décrit en détail car un tel dispositif met en oeuvre des éléments classiques permettant simplement, à partir de modules de concaténation aux paquets de données $P_j$ de n valeurs stables en début et en fin de paquet, d'alimenter en fait un codeur convolutif tel que décrit en figure 1.

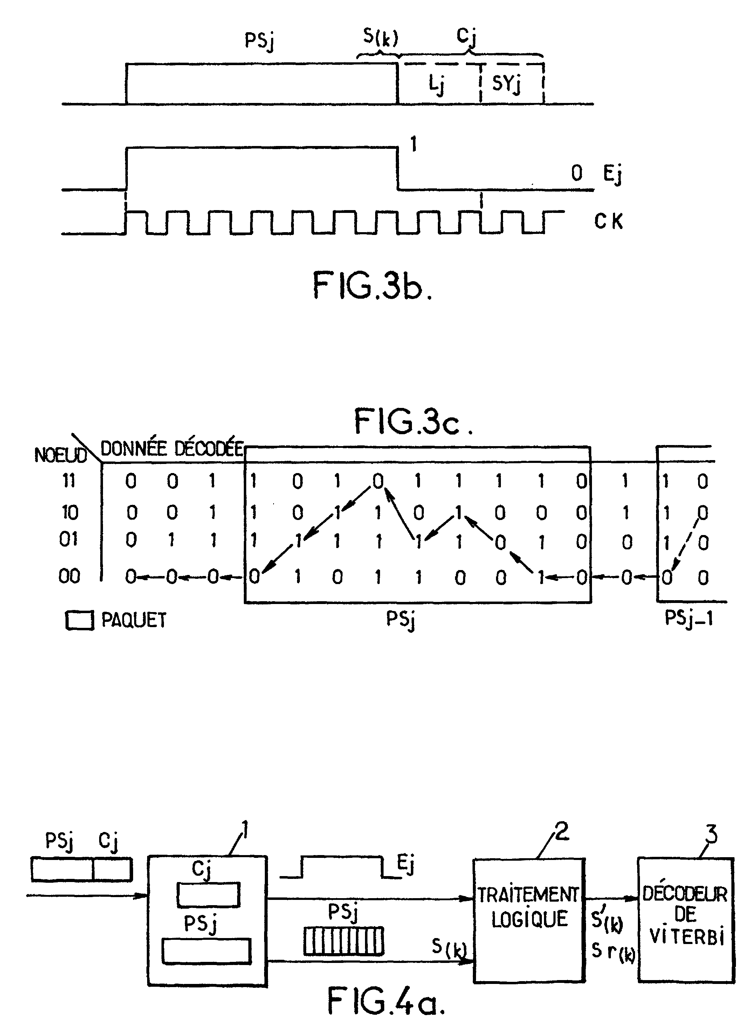

Un procédé de décodage d'un flux série de données numériques codées par codage convolutif et transmises par paquets, conformément au procédé objet de la présente invention tel que décrit en figures 2a et 2b, sera maintenant donné en liaison avec la figure 3a et la figure 3b.

D'une manière générale, on rappelle que dans un mode de réalisation préférentiel non limitatif, la mise en oeuvre du procédé de codage, objet de la présente invention, a pour effet d'engendrer la transmission d'un message résultant tel que représenté en figure 2b. Ce message résultant comprend le message d'encapsulation $C_j$, relatif au paquet de données $P_j$, et le message constitué par les symboles codés $PS_j$ relatif au même paquet de données précité.

Dans ces conditions, ainsi que représenté en figure 3a, le procédé de décodage, objet de la présente invention, consiste, à la réception du message d'encapsulation $C_j$ et du paquet de symboles codés $PS_j$ précité, l'étape de réception étant notée a') sur la figure 3a, à réaliser au moins une étape b') consistant à discriminer le message d'encapsulation $C_j$ pour engendrer un signal logique d'enveloppe $E_j$ présentant une première valeur binaire antérieurement au début et postérieurement à la fin du paquet de symboles codés $PS_j$, et une deuxième valeur binaire pendant la réception du paquet de symboles codés $PS_j$ précité.

L'étape b') est elle-même suivie d'une étape c') consistant à soumettre le signal logique d'enveloppe $E_j$ et les symboles codés $S(k)$ à un traitement logique permettant d'engendrer, d'une part, pour la première valeur binaire du signal logique d'enveloppe $E_j$, des symboles de repos de rang successif de valeur déterminée, et, d'autre part, pour la deuxième valeur binaire du signal logique d'enveloppe, des symboles codés validés de rang successif k, ces symboles codés validés étant notés $S'(k) = \{a'(k);b'(k)\}$. Bien entendu, les symboles codés validés correspondent aux symboles codés $S(k)$ d'origine pendant la deuxième valeur binaire du signal logique d'enveloppe précité.

On comprend en particulier que le traitement logique, noté * sur la figure 3a, permet en fait de réaliser l'opération :

$$S(k)*E_j$$

cette opération logique étant définie en fonction, d'une part, de la valeur logique effective de la première valeur logique du signal logique d'enveloppe, et, d'autre part, en fonction de la valeur de repos allouée au processus de codage convolutif proprement dit, ainsi qu'il sera exposé ultérieurement dans la description.

Enfin, l'étape c') représentée en figure 3a est suivie d'une étape d') consistant à soumettre les symboles de repos et symboles codés validés de rang successif à un décodage de type VITERBI continu, les symboles de repos permettant d'assurer la continuité du treillis de décodage par maintien d'un état stable à partir de la valeur stable de départ entre deux paquets de symboles codés successifs.

On comprend bien entendu que le traitement logique appliqué aux symboles codés à partir du signal logique d'enveloppe permet en fait, pour le processus de décodage de VITERBI proprement dit, d'engendrer des valeurs de symboles de repos spécifiques correspondant aux valeurs stables de départ, afin de permettre de réaliser un décodage de VITERBI de type continu.

Le processus de création du signal logique d'enveloppe, à partir du message d'encapsulation $C_j$ tel que décrit en liaison avec la figure 3a à l'étape b'), sera maintenant décrit en liaison avec la figure 3b.

En référence à la figure précitée, on indique que sur détection du mot de synchronisation $SY_j$, par exemple par comparaison du champ relatif au mot de synchronisation dans le message d'encapsulation $C_j$ à un mot de référence, puis sur lecture de la valeur de longueur $L_j$, le processus de création du signal logique d'enveloppe $E_j$ peut simplement consister à engendrer un signal logique à une première valeur binaire, la valeur zéro par exemple représentée en figure 3b, dès la reconnaissance du mot de synchronisation $SY_j$ par exemple, puis passer à la valeur complémentée de cette première valeur logique, la valeur 1 sur la figure 3b, au bout d'un nombre déterminé de cycles d'horloge correspondant à la transmission effective du champ de longueur $L_j$ précité. Sur la figure 3b, le signal d'horloge précité est noté CK. La valeur complémentée, la valeur 1 relative au signal logique d'enveloppe correspondant à une deuxième valeur logique de ce dernier, peut alors être maintenue pendant la durée en nombres de cycles d'horloge correspondant à la lecture des symboles codés successifs constitutifs du paquet de symboles $PS_j$, puis ramenée à la première valeur logique, la valeur zéro, dès la fin du processus de lecture mentionné précédemment en coïncidence avec la fin de la lecture du paquet de symboles précité.

Le processus de décodage de VITERBI réalisé à l'étape d') mentionnée en liaison avec la figure 3a est alors le suivant.

La continuité dans le treillis, diagramme spécifique au décodage de VITERBI, est obtenu par maintien de l'état stable à partir de la valeur stable précitée entre deux paquets consécutifs de rang j et j+1. Cet état stable est celui qui, à coup sûr, représente la donnée codée et émise en début et en fin de paquet, état qui est maintenu entre deux paquets successifs.

Dans un treillis, il n'existe que deux états correspondant à ces critères, l'état zéro et l'état 1 correspondant aux valeurs stables précitées en fonction de la profondeur K du processus de codage utilisé. Cet état est égal à 3 pour K = 3 et à 63 pour K = 7.

Conceptuellement, l'algorithme de VITERBI garantit en effet que, lorsqu'on est dans l'état zéro du treillis et que l'on reçoit toujours des zéros, on ne change pas l'état de ce dernier, aucune divergence n'étant introduite entre la valeur reçue et la valeur espérée. Il en est de même pour un état 1 avec la réception d'une valeur 1.

Par ailleurs, si le processus de codage utilise comme valeur stable de départ ou de repos la valeur zéro prise comme valeur de contrainte, par construction, l'algorithme de VITERBI implique que le chemin le plus probable en fin de réception d'un paquet de symboles $PS_j$ part du noeud ou de l'état zéro de ce treillis et que le paquet ultérieur commencera au même noeud. Le même principe est bien entendu applicable pour une valeur de contrainte ou de repos égale à 1, l'état de début et de fin de paquet correspondant alors à n valeurs 1.

Une représentation d'un treillis dans un processus de décodage de VITERBI pour K = 3 avec une valeur de contrainte ou valeur stable égale à zéro est représentée en figure 3c, pour des paquets successifs $PS_{j-1}$, $PS_j$.

Le procédé de codage convolutif et de transmission par paquets d'un flux série de données numériques et le procédé de décodage correspondant, objets de la présente invention, permettent, au niveau du procédé de décodage, de forcer le treillis à rester à l'état stable ou état de repos établi à partir des valeurs stables de départ entre deux paquets successifs, et donc de ne jamais interrompre le traitement des données, même dans le mode de transmission par paquets.

Alors que le mode de transmission par paquets consiste à émettre des données en rafales et à espacer ces rafales dans le temps, ce mode induisant donc des ruptures dans la continuité logique des données émises et ne pouvant donc pas a priori être soumis à un décodage de type VITERBI, le flux des données dans les procédés, objets de la présente invention, n'est jamais interrompu. En effet, l'état de repos apparaît comme l'état naturel de la suite du processus et il n'est donc pas nécessaire de modifier le coeur de l'architecture du décodeur de VITERBI mis en oeuvre pour opérer en mode paquets.

On comprend ainsi que, par la création du signal logique d'enveloppe à partir du message d'encapsulation, le traitement logique entre les symboles codés et le signal logique d'enveloppe permet simplement d'assurer une telle continuité.

On comprend bien sûr que le processus ou mode opératoire du codeur suit rigoureusement le processus ou mode opératoire du traitement logique au niveau du décodage.

Différents modes de réalisation du traitement logique seront maintenant donnés en liaison avec la forme du signal d'encapsulation et la valeur de repos retenue.

Conformément à un premier mode de réalisation du traitement logique précité, pour un état de repos ainsi que pour une première valeur logique du signal logique d'enveloppe correspondant à la signalisation du début et de la fin de paquet égal à la valeur zéro, et pour une deuxième valeur logique du signal logique d'enveloppe égale à la valeur 1, le traitement logique est un traitement logique par une fonction logique ET.

Dans un tel cas, si le signal logique d'enveloppe est inactif, c'est-à-dire à la première valeur logique zéro, les données entrantes sont remplacées par une valeur zéro, ce qui maintient bien entendu le treillis à l'état zéro, c'est-à-dire à l'état de repos.

Dans un deuxième mode de réalisation, pour un état de repos égal à la valeur 1, une première valeur logique préalable au début et postérieure à la fin du paquet de symboles codés du signal logique d'enveloppe égale à la valeur 1, et pour une deuxième valeur logique, activité de l'enveloppe, égale à la valeur 0, le traitement logique réalisé entre le signal logique d'enveloppe et les symboles codés S(k) est une fonction logique de type OU avec le signal logique d'enveloppe complémenté.

Dans un troisième mode de réalisation, pour un état de repos et une première valeur logique du signal logique d'enveloppe égaux à la valeur zéro et pour un signal représentant l'activité de l'enveloppe correspondant à la deuxième valeur logique de cette dernière égale à la valeur un, le traitement logique entre le signal logique d'enveloppe et les symboles codés est une fonction de type ET avec le signal logique d'enveloppe complémenté.

Dans un quatrième mode de réalisation, pour un état de repos et une première valeur logique du signal logique d'enveloppe égaux à la valeur 1 et pour un signal d'activité de l'enveloppe correspondant à la deuxième valeur logique d'enveloppe égal à la valeur zéro, le traitement logique entre les symboles S(k) et le signal logique d'enveloppe est une fonction de type OU avec le signal logique d'enveloppe précité.

D'autres modes de réalisation peuvent être envisagés.

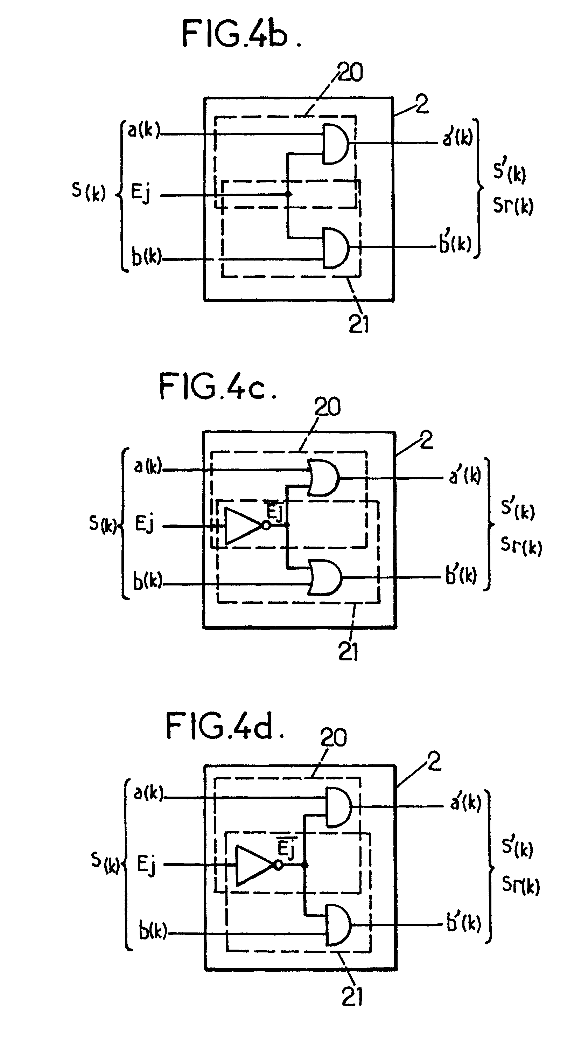

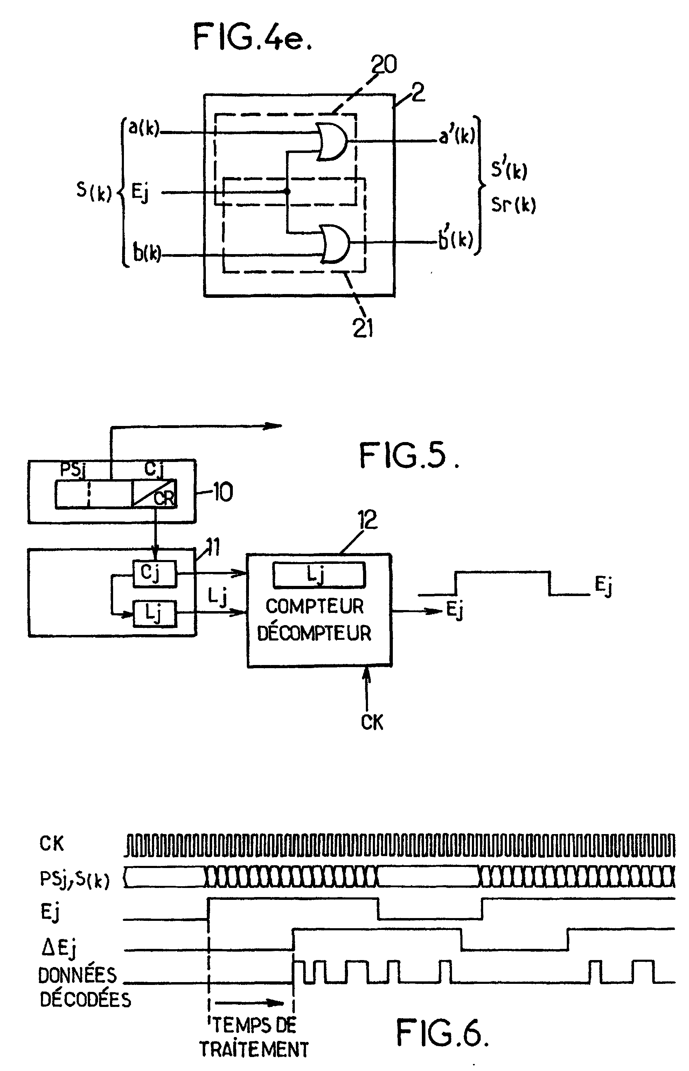

Une description plus détaillée d'un dispositif de décodage d'un flux série de données numériques codées par codage convolutif et transmises par paquets, conformément au procédé de codage précédemment décrit dans la description, sera maintenant donnée en liaison avec les figures 4a à 4d.

Compte tenu de la structure du message résultant transmis, tel que représenté en figure 2b, le dispositif tel que représenté en figure 4a peut comporter avantageusement un module 1 de discrimination du message d'encapsulation $C_j$ permettant d'engendrer un signal logique d'enveloppe $E_j$ ainsi que mentionné précédemment relativement au paquet de symboles $PS_j$ courant. Le signal logique d'enveloppe $E_j$ présente une première et une deuxième valeur logique, ainsi que mentionné précédemment.

Le dispositif de décodage comporte en outre un module 2 de traitement logique du signal logique d'enveloppe et des symboles codés S(k) représentatifs des données codées. Le module 2 reçoit le signal logique d'enveloppe $E_J$ et les symboles S(k). le module de traitement logique 2, grâce à la mise en oeuvre des fonctions logiques précitées, permet d'engendrer un flux continu de données numériques constituées par le paquet de symboles codés successifs auxquels peuvent être associés les symboles de repos, notés Sr(k) correspondant à l'état de repos.

Enfin, le dispositif de décodage comprend un module 3 de décodage de VITERBI recevant le flux continu de données numériques précité, ce module de décodage étant ainsi réactualisé à l'état de repos à partir du signal enveloppe, grâce à l'introduction des symboles de repos Sr(k), cette opération étant bien entendu réalisée pour chaque paquet courant $PS_j$.

D'une manière générale, on indique que le module 2 de traitement logique comprend une première cellule logique 20 recevant, sur une première entrée, chaque premier élément de symboles a(k) et, sur une deuxième entrée, le signal logique d'enveloppe $E_j$, cette première cellule logique 20 délivrant un premier élément de symboles validés a'(k). En outre, le module 2 de traitement logique comprend une deuxième cellule logique 21 recevant, sur une première entrée, chaque deuxième élément de symboles b(k) et, sur une deuxième entrée, le signal logique d'enveloppe $E_j$, et délivrant un deuxième élément de symboles validés b'(k).

Les première 20 et deuxième 21 cellules logiques seront maintenant décrites en liaison avec les différentes fonctions logiques mises en oeuvre, précédemment mentionnées dans la description.

Lorsque la fonction logique est une fonction de type ET, chaque première 20 et deuxième 21 cellule logique comprend une porte ET recevant le signal logique d'enveloppe $E_j$ sur l'une de leurs entrées et l'élément de symbole a(k), b(k) respectivement sur l'autre de leurs entrées, pour délivrer le symbole codé validé S'(k) ou le symbole de repos Sr(k).

Lorsque le traitement logique correspond à une fonction logique de type OU avec le signal d'enveloppe complémenté, la première 20 et la deuxième cellule logique 21 sont formées par une porte OU recevant sur une de leurs entrées le signal logique d'enveloppe $E_j$ par l'intermédiaire d'un inverseur, et sur l'autre de leurs entrées, l'élément de symbole a(k), b(k) pour délivrer le symbole codé validé S'(k) et le symbole de repos Sr(k).

Lorsque le traitement logique correspond à une fonction logique de type ET avec le signal logique d'enveloppe complémenté, la première 20 et la deuxième cellule logique 21 comportent une porte ET dont l'une des entrées reçoit le signal logique d'enveloppe par l'intermédiaire d'un inverseur et l'autre des entrées reçoit l'élément de symbole correspondant a(k), b(k) pour délivrer le symbole codé validé S'(k) ou le symbole de repos Sr(k).

Lorsque le traitement logique correspond à une fonction logique de type OU entre les éléments de symbole des symboles codés a(k), b(k) et le signal logique d'enveloppe $E_j$, la première 20 et la deuxième cellule logique 21 consistent en une porte OU recevant, sur une de leurs entrées le signal logique d'enveloppe $E_j$ et sur l'autre de leurs entrées, l'élément de symbole a(k), respectivement b(k) pour délivrer les symboles codés validés S'(k) ou symboles de repos Sr(k).

Enfin, un mode de réalisation non limitatif du module 1 de discrimination du message d'encapsulation $C_j$ sera décrit dans un mode préférentiel de réalisation, en liaison avec la figure 5. Selon la figure 5 précitée, le module 1 de discrimination du message d'encapsulation peut comprendre un dispositif 10 d'alignement permettant de détecter dans le message d'encapsulation le mot de synchronisation $SY_j$. Le dispositif d'alignement peut, de manière classique, consister en une mémoire de taille suffisante permettant une lecture du champ relatif au mot de synchronisation $SY_j$ et comparaison des valeurs lues de ce champ à un message de référence, noté CR. Sur correspondance des valeurs lues entre les deux champs, la valeur mémorisée dans le champ de longueur $L_j$ du message d'encapsulation $C_j$ peut alors être chargée dans un circuit de lecture 11, tel que représenté en figure 5.

Enfin, le module 1 de discrimination du message d'encapsulation peut comprendre également un compteur/décompteur 12, lequel est chargé, à partir de la valeur de longueur lue dans le champ $L_j$, ce compteur/décompteur permettant d'engendrer le signal d'enveloppe $E_j$ dont l'un des états logiques présente une durée proportionnelle à la valeur de longueur $L_j$ précitée. On comprend ainsi que le compteur/décompteur joue, en quelque sorte, le rôle d'un circuit monostable dont l'état métastable est ajusté en fonction de la valeur de longueur chargée dans ce dernier. Bien entendu, le compteur/décompteur est normalement piloté par un signal d'horloge CK tel que mentionné précédemment dans la description.

Enfin, il est souhaitable d'indiquer, après le processus de décodage de VITERBI appliqué aux symboles codés précités, quelles sont en fait les données utiles, c'est-à-dire les données obtenues autres que celles relatives au décodage des symboles de repos.

Dans ce but, le signal logique d'enveloppe $E_j$ peut donc être décalé et retardé du temps de traitement nécessaire au décodage d'une ou plusieurs données, ainsi que représenté en figure 6, ce signal logique d'enveloppe décalé $\Delta E_j$ permettant en fait de synchroniser et de discriminer les données obtenues par décodage des seuls symboles codés validés.

Le procédé de codage, le procédé de décodage et le dispositif de décodage, objets de la présente invention, peuvent être utilisés de manière particulièrement avantageuse dans toutes applications soumises à une conversion de données numériques/analogiques puis analogiques/numériques et nécessitant une détection de la correction d'erreurs.

Ils sont particulièrement avantageux et adaptés à toutes applications qui requièrent que le multiplexage de données soit réalisé dans la couche physique du réseau de transmission. Ainsi, tous réseaux de communication de paquets opérant des transmissions en mode non connecté et nécessitant impérativement la mise en oeuvre d'un processus de correction d'erreurs peuvent être soumis à un processus de codage d'un canal dont les extrémités sont composées d'un codeur convolutif et d'un décodeur de type VITERBI tels que décrits précédemment dans la description.

## Revendications

**1.** Procédé de codage convolutif et de transmission par paquets d'un flux série de données numériques, succession de bits i(k) de valeur déterminée, au moyen d'un codage convolutif de longueur de contrainte K, dans lequel sont mises en oeuvre les étapes suivantes :

a) discriminer dans ledit flux série un ensemble de bits successifs, pour former un paquet courant ;
b) définir pour ledit codage convolutif une valeur binaire stable de départ ;
c) soumettre lesdites données numériques i(k) du paquet courant à un processus de codage convolutif, à chaque valeur de bit i(k) correspondant une première a(k) et une deuxième b(k) valeur codée, l'ensemble de ces première et deuxième valeurs codées constituant un symbole S(k) = {a(k);b(k)} codé représentatif du bit i (k) considéré ;
d) former, à partir des symboles codés, un paquet de symboles codés par concaténation de ces symboles codés,
e) imposer au processus de codage convolutif la valeur stable précitée comme valeur de contrainte en fin de paquet ;
f) engendrer au moins un message d'encapsulation dudit paquet de symboles codés, comportant un champ de longueur de paquet ($L_j$) ;
g) transmettre en un même message ledit message d'encapsulation et ledit paquet de symboles codés pour décodage et utilisation ;
h) répéter les opérations a) à g) pour chaque paquet courant constitutif dudit flux de bits.

**2.** Procédé de décodage d'un flux série de données numériques, codées par un codage convolutif utilisant une valeur binaire stable de départ, et transmises par paquets, dans lequel sont mises en oeuvre les étapes suivantes :

a')- recevoir un paquet de symboles codés S(k) ainsi qu'un

message d'encapsulation comportant un champ de longueur de ce paquet $(L_j)$ ;

b')- discriminer ledit message d'encapsulation pour engendrer, en fonction de la longueur du paquet, un signal logique d'enveloppe présentant une première valeur binaire antérieurement au début et postérieurement à la fin dudit paquet de symboles codés et une deuxième valeur binaire pendant la réception dudit paquet de symboles codés;

c')- soumettre ledit signal logique d'enveloppe et lesdits symboles codés à un traitement logique permettant d'engendrer :

α) pour ladite première valeur binaire dudit signal logique d'enveloppe des symboles de repos de rang successif de valeur déterminée fonction de ladite valeur stable de départ, et

β) pour ladite deuxième valeur binaire dudit signal logique d'enveloppe des symboles codés validés, de rang successif k, $S'(k) = \{a'(k);b'(k)\}$ correspondant auxdits symboles S(k) ;

d')- soumettre lesdits symboles de repos et symboles codés validés de rang successif à un décodage de type VITERBI, continu, lesdits symboles de repos permettant d'assurer la continuité du treillis de décodage par maintien d'un état stable entre deux paquets de symboles codés successifs.

3. Procédé de décodage selon la revendication 2, **caractérisé en ce que**, pour un état de repos ainsi que pour une première valeur logique du signal logique d'enveloppe correspondant à la signalisation de début et de fin de paquet égale à la valeur zéro et pour une deuxième valeur logique du signal logique d'enveloppe égale à la valeur 1, ledit traitement logique consiste à appliquer à chaque symbole a(k), b(k) reçu une fonction ET logique avec ledit signal logique d'enveloppe.

4. Procédé de décodage selon la revendication 2, **caractérisé en ce que**, pour un état de repos ainsi que pour une première valeur logique du signal logique d'enveloppe correspondant à la signalisation de début et de fin de paquet égale à la valeur un et pour une deuxième valeur logique du signal logique d'enveloppe égale à la valeur 0, ledit traitement logique consiste à appliquer à chaque symbole a(k), b(k) une fonction OU avec ledit signal logique d'enveloppe complémenté.

5. Procédé de décodage selon la revendication 2, **ca-**

**ractérisé en ce que**, pour un état de repos et une première valeur logique du signal logique d'enveloppe égaux à la valeur zéro, et pour un signal représentant l'activité de l'enveloppe correspondant à la deuxième valeur logique égale à la valeur 1, ledit traitement logique consiste à appliquer à chaque symbole a(k), b(k) une fonction ET avec ledit signal logique d'enveloppe complémenté.

6. Procédé de décodage selon la revendication 2, **caractérisé en ce que**, pour un état de repos et une première valeur logique du signal logique d'enveloppe égaux à la valeur 1, et pour un signal d'activité de l'enveloppe correspondant à la deuxième valeur logique d'enveloppe égale à la valeur 0, ledit traitement logique consiste à appliquer à chaque symbole a(k), b(k) une fonction OU avec ledit signal logique d'enveloppe.

7. Dispositif de décodage d'un flux série de données numériques, codées par un codage convolutif utilisant une valeur binaire stable de départ, et transmises par paquets, comportant :

- des moyens pour recevoir un paquet de symboles codés S(k) ainsi qu'un message d'encapsulation comportant un champ de longueur de ce paquet $(L_j)$ ;

- des moyens de discrimination dudit message d'encapsulation pour engendrer, en fonction de la longueur du paquet, un signal logique d'enveloppe présentant une première valeur binaire antérieurement au début et postérieurement à la fin dudit paquet de symboles codés et une deuxième valeur binaire pendant la réception dudit paquet de symboles codés;

- des moyens de traitement logique pour engendrer :

α) pour ladite première valeur binaire dudit signal logique d'enveloppe, des symboles de repos de rang successif de valeur déterminée fonction de ladite valeur stable de départ, et

β) pour ladite deuxième valeur binaire dudit signal logique d'enveloppe, des symboles codés validés, de rang successif k, $S'(k) = \{a'(k);b'(k)\}$ correspondant auxdits symboles S(k) ;

- et des moyens de décodage de VITERBI pour effectuer, à partir desdits symboles de repos et symboles codés validés de rang successif, un décodage de type VITERBI, continu, lesdits symboles de repos permettant d'assurer la continuité du treillis de décodage par maintien d'un état stable entre deux paquets de symboles codés successifs.

**8.** Dispositif selon la revendication 7, **caractérisé en ce que** lesdits moyens de traitement logique comprennent au moins :

- une première cellule logique recevant, sur une première entrée, chaque premier élément de symbole a(k), et, sur une deuxième entrée, ledit signal logique d'enveloppe et délivrant un premier élément de symbole validé a'(k) ;
- une deuxième cellule logique recevant, sur une première entrée, chaque deuxième élément de symbole b(k), et, sur une deuxième entrée, ledit signal logique d'enveloppe, et délivrant un deuxième élément de symbole validé b'(k).

**9.** Dispositif selon la revendication 8, **caractérisé en ce que** la première et la deuxième cellule logiques sont constituées par une même porte logique, munie chacune d'une première et d'une deuxième entrée, la première entrée de chaque porte logique constituant la première entrée de chaque cellule logique et la deuxième entrée de chaque porte logique étant connectée à la deuxième entrée de chaque cellule logique directement ou par l'intermédiaire d'un inverseur logique, en fonction de la valeur logique assignée à la première, respectivement deuxième valeur binaire dudit signal enveloppe.

**10.** Dispositif selon l'une des revendications 7 à 9, **caractérisé en ce que** lesdits moyens de discrimination dudit message d'encapsulation comprennent :

- un dispositif d'alignement permettant de détecter, dans le message d'encapsulation, un mot de synchronisation ;
- un circuit de lecture, dans le message d'encapsulation, d'un champ de longueur de message ;
- un compteur-décompteur chargé à partir de la valeur de longueur lue et permettant d'engendrer le signal d'enveloppe dont l'un des états logiques présente une durée proportionnelle à ladite valeur de longueur.

**Patentansprüche**

**1.** Verfahren zur Faltungskodierung und zur Paketübertragung eines seriellen Flusses digitaler Daten, nämlich einer Folge von Bits i(k) mit bestimmtem Wert, mittels einer Faltungskodierung mit Länge K, umfassend die folgenden Schritte:

a) Unterscheiden einer Menge aufeinanderfolgender Bits in dem seriellen Fluss, um ein laufendes Paket zu bilden;

b) Definieren eines stabilen Startbinärwerts für die Faltungskodierung;

c) Unterziehen der digitalen Daten i(k) des laufenden Pakets eines Faltungskodierprozesses, wobei jedem Bitwert i(k) ein erster a(k) und zweiter b(k) Kodierwert entspricht, und die Menge der ersten und zweiten Kodierwerte ein kodiertes Symbol S(k) = {a(k); b(k)} bildet, das für das betrachtete Bit i(k) repräsentativ ist;

d) ausgehend von den kodierten Symbolen, Bilden eines Pakets aus kodierten Symbolen durch Konkatenierung der kodierten Symbole,

e) dem Prozess der Faltungskodierung den zuvor genannten stabilen Wert als Zwangswert am Paketende auferlegen;

f) Erzeugen mindestens einer Verkapselungsmitteilung des Pakets von kodierten Symbolen, umfassend ein Paketlängenfeld ($L_j$);

g) in einer gleichen Mitteilung, Übertragen der Verkapselungsmitteilung und des Pakets von kodierten Symbolen, für die Dekodierung und Verwendung;

h) Wiederholen der Vorgänge a) bis g) für jedes laufende Paket, das den Bitfluss bildet.

**2.** Verfahren zum Dekodieren eines seriellen Flusses digitaler Daten, die durch eine Faltungskodierung unter Verwendung eines stabilen Anfangsbinärwerts kodiert und durch Pakete übertragen wurden, umfassend die folgenden Schritte:

a') Empfangen eines Pakets von kodierten Symbolen S(k) und einer Verkapselungsmitteilung, welche ein Längenfeld dieses Pakets ($L_j$) umfasst;

b') Unterscheiden der Verkapselungsmitteilung, um abhängig von der Länge des Pakets ein Umhüllungslogiksignal zu erzeugen, das einen ersten Binärwert vor Beginn und nach Ende des Pakets von kodierten Symbolen aufweist, und einen zweiten Binärwert während des Empfangs des Pakets von kodierten Symbolen;

c') Unterwerfen des Umhüllungslogiksignals und der kodierten Signale einer Logikverarbeitung, welche zu erzeugen gestattet:

α) für den ersten Binärwert des Umhüllungslogiksignals, Ruhesymbole von aufeinanderfolgendem Rang mit bestimmtem Wert, abhängig von dem stabilen Anfangswert, und

β) für den zweiten Binärwert des Umhüllungslogiksignals, validierte kodierte Symbole, von aufeinanderfolgendem Rang k, wobei S'(k) = {a'(k); b'(k)} den Symbolen S(k) entspricht;

d') Unterwerfen der Ruhesymbole und validierten kodierten Symbole von aufeinanderfolgendem Rang einer VITERBI-Dekodierung, fortgesetzt, wobei die Ruhesymbole es gestatten, die Kontinuität des Kodierungsrasters sicherzustellen, durch Wahrung eines stabilen Zustands zwischen zwei aufeinanderfolgenden Paketen von kodierten Symbolen.

3. Verfahren zum Dekodieren nach Anspruch 2, **dadurch gekennzeichnet, dass** für einen Ruhezustand und einen ersten Logikwert des Umhüllungslogiksignals, der der Paketanfangs- und Paketendesignalsierung gleich dem Wert null entspricht, und für einen zweiten Logikwert des Umhüllungslogiksignals gleich dem Wert 1, die logische Verarbeitung darin besteht auf jedes empfangene Symbol a(k), b(k) eine logische UND-Funktion mit dem Umhüllungslogiksignal anzuwenden.

4. Verfahren zum Dekodieren nach Anspruch 2, **dadurch gekennzeichnet, dass** für einen Ruhezustand und einen ersten Logikwert des Umhüllungslogiksignals, der der Paketanfangs- und Paketendesignalisierung gleich dem Wert eins entspricht, und für einen zweiten Logikwert des Umhüllungslogiksignals gleich dem Wert 0, die logische Verarbeitung darin besteht auf jedes Symbol a(k), b(k) eine ODER-Funktion mit dem komplementären Umhüllungslogiksignal anzuwenden.

5. Verfahren zum Dekodieren nach Anspruch 2, **dadurch gekennzeichnet, dass** für einen Ruhezustand und einen ersten Logikwert des Umhüllungslogiksignals gleich dem Wert null, und für ein Signal, das die Aktivität der Umhüllung darstellt, das dem zweiten Logikwert gleich dem Wert 1 entspricht, die logische Verarbeitung darin besteht auf jedes Symbol a(k), b(k) eine UND-Funktion mit dem komplementären Umhüllungslogiksignal anzuwenden.

6. Verfahren zum Dekodieren nach Anspruch 2, **dadurch gekennzeichnet, dass** für einen Ruhezustand und einen ersten Logikwert des Umhüllungslogiksignals gleich dem Wert 1, und für ein Umhüllungsaktivitätssignal, das dem zweiten Umhüllungslogikwert gleich dem Wert null entspricht, die Logikverarbeitung darin besteht auf. jedes Symbol a(k), b(k) eine ODER-Funktion mit dem Umhüllungslogiksignal anzuwenden.

7. Vorrichtung zum Dekodieren eines seriellen Flusses digitaler Daten, die durch eine Faltungskodierung unter Verwendung eines stabilen Anfangsbinärwerts kodiert und durch Pakete übertragen wurden, umfassend:

- Mittel zum Empfangen eines Pakets von kodierten Symbolen S(k) und einer Verkapselungsmitteilung, welche ein Längenfeld dieses Pakets ($L_j$) umfasst;

- Mittel zum Unterscheiden der Verkapselungsmitteilung, um abhängig von der Länge des Pakets ein Umhüllungslogiksignal zu erzeugen, das einen ersten Binärwert vor Beginn und nach Ende des Pakets von kodierten Symbolen aufweist, und einen zweiten Binärwert während des Empfangs des Pakets von kodierten Symbolen;

- Mittel zur logischen Verarbeitung, um zu erzeugen:

  α) für den ersten Binärwert des Umhüllungslogiksignals, Ruhesymbole von aufeinanderfolgendem Rang mit bestimmtem Wert, abhängig von dem stabilen Anfangswert, und
  β) für den zweiten Binärwert des Umhüllungslogiksignals, validierte kodierte Symbole von aufeinanderfolgendem Rang k, wobei S'(k) = {a'(k); b'(k)} den Symbolen S(k) entspricht;

- und VITERBI-Dekodierungsmittel, um ausgehend von den Ruhesymbolen und den validierten kodierten Symbolen aufeinanderfolgenden Rangs eine VITERBI-Dekodierung durchzuführen, fortgesetzt, wobei die Ruhesymbole es gestatten, die Kontinuität des Dekodierungsrasters sicherzustellen, durch Wahrung eines stabilen Zustands zwischen zwei aufeinanderfolgenden Paketen von kodierten Symbolen.

8. Vorrichtung nach Anspruch 7, **dadurch gekennzeichnet, dass** die Mittel zur logischen Verarbeitung mindestens umfassen:

- eine erste Logikzelle, die an einem ersten Eingang jedes erste Symbolelement a(k) empfängt, und an einem zweiten Eingang das Umhüllungslogiksignal, und ein erstes validiertes Symbolelement a'(k) ausgibt;

- eine zweite Logikzelle, die an einem ersten Eingang jedes zweite Symbolelement b(k) empfängt, und an einem zweiten Eingang das Umhüllungslogiksignal, und ein zweites validiertes Symbolelement b'(k) ausgibt.

**9.** Vorrichtung nach Anspruch 8, **dadurch gekennzeichnet, dass** die erste und zweite Logikzelle durch ein gleiches Logiktor gebildet sind, jedes ausgestattet mit einem ersten und einem zweiten Eingang, wobei der erste Eingang jedes Logiktors den ersten Eingang jeder Logikzelle bildet, und der zweite Eingang jedes Logiktors mit dem zweiten Eingang jeder Logikzelle direkt oder unter Zwischenschaltung eines logischen Inverters verbunden ist, abhängig von dem Logikwert, der dem ersten bzw. zweiten Binärwert des Umhüllungssignals zugewiesen ist.

**10.** Vorrichtung nach einem der Ansprüche 7 bis 9, **dadurch gekennzeichnet, dass** die Mittel zur Unterscheidung der Verkapselungsmitteilung umfassen:

- eine Ausrichtungsvorrichtung, welche es gestattet in der Verkapselungsmitteilung ein Synchronisationswort zu erfassen;

- eine Schaltung, um in der Verkapselungsmitteilung ein Mitteilungslängenfeld zu lesen;

- ein Aufwärts/Abwärts-Zähler, der anfangs mit dem gelesenen Längenwert geladen wird, und es gestattet, das Umhüllungssignal zu erzeugen, von welchem einer der Logikzustände eine Dauer aufweist, die dem Längenwert proportional ist.

**Claims**

**1.** A method for convolutive encoding and transmission by packets of a digital data series flow which is formed by a successive number of bits i(k) of specified value, through a convolutive encoding of depth K, said method comprising the following steps:

a) discriminating in said series flow a set of successive bits, in order to form a current packet ;
b) defining for said convolutive encoding a stabl'e starting binary value ;
c) subjecting said digital data i(k) of the current packet to a convolutive encoding process, at each value of bit i(k) corresponding to a first a (k) and a second b(k) encoded value, the set of these first and second encoded values constituting an encoded symbol S(k) = {a(k);b(k)} representative of the considered bit i(k) ;
d) forming, from the encoded symbols, a packet of encoded symbols by concatenation of said encoded symbols ;
e) assigning to said convolutive encoding process said aforementioned stable value as a constraint value at the end of said packet;

f) generating at least one encapsulation message of said packet of encoded symbols, comprising a packet length field (Lj);
g) transmitting in the same message said encapsulation message and said packet of encoded symbols for decoding and use ;
h) repeating the operations a) to g) for each current packet constituting said flow of bits.

**2.** A method for decoding a digital data series flow encoded by convolutive encoding using a stable starting binary value and transmitted by packets, comprising the following steps:

a') receiving a packet of encoded symbols S(k) and an encapsulation message comprising a field indicating the length (Lj) of this packet;
b') discriminating said encapsulation message in order to generate, on the basis of the packet length, an envelope logic signal having a first binary value prior to the start and subsequently at the end of said packet of encoded symbols and a second binary value during the reception of said packet of encoded symbols;
c') subjecting said envelope logic signal and said encoded symbols to a logic processing enabling to generate:

α) successive pause symbols of specified value and rank, on the basis of said stable starting binary value, for said first binary value of said envelope logic signal, and
β) successive validated encoded symbols S'k = {a'(k);b'(k)} of rank k corresponding to said symbols S(k) for said second binary value of said envelope logic signal;

d') subjecting said successive pause symbols and validated encoded symbols of given rank to a continuous VITERBI type decoding, said pause symbols enabling the continuity of the decoding lattice to be obtained by imposing a stable state between two packets of successive encoded symbols.

**3.** A decoding method according to claim 2, wherein for a pause state as well as for a first logic value of said envelope logic signal corresponding to the signalling of the packet start and end equal to the value zero and for a second logic value of said envelope logic signal equal to the value 1, said logic processing consists in applying to each received symbol a (k), b(k) an AND logic function with said envelope logic signal.

**4.** A decoding method according to claim 2, wherein for a pause state as well as for a first logic value of said envelope logic signal corresponding to the signalling of the packet start and end equal to the value 1 and for a second logic value of said envelope logic signal equal to the value 0, said logic processing consists in applying to each symbol a(k), b(k) an OR function with said complemented envelope logic signal.

5. A decoding method according to claim 2, wherein for a pause state and a first logic value of said envelope logic signal equal to the value 0, and for a signal representing the activity of the envelope corresponding to the second logic value equal to the value 1, said logic processing consists in applying to each symbol a(k), b(k) an AND function with said complemented envelope logic signal.

6. A decoding method according to claim 2, wherein for a pause state and a first logic value of said envelope logic signal equal to the value 1, and for a signal representing the activity of the envelope corresponding to the second envelope logic value equal to 0, said logic processing consists in applying to each symbol a(k), b(k) an OR function with said envelope logic signal.

7. A decoding device for a series flow of digital data encoded by convolutive encoding using a stable starting binary value and transmitted by packets comprising:

   - means for receiving a packet of encoded symbols S(k) and an encapsulation message comprising a packet length field (Lj);
   - discrimination means of said encapsulation message enabling an envelope logic signal to be generated for said current packet, on the basis of the packet length, said envelope logic signal having a first logic value before the beginning and after the end of the encoded symbol packet and a second logic value during the receiving of the packet;
   - logic processing means for generating :

     $\alpha$) successive pause symbols of specified value and rank, on the basis of said stable starting binary value, for said first binary value of said envelope logic signal, and
     $\beta$) successive validated encoded symbols S'k = {a'(k);b'(k)} of rank k corresponding to said symbols S(k) for said second binary value of said envelope logic signal;

   - and VITERBI decoding means for carrying out, on the basis of said pause symbols and validated encoded symbols of given rank, a continuous VITERBI type decoding, said pause symbols enabling the continuity of the decoding lattice to be obtained by imposing a stable state between two packets of successive encoded symbols.

8. A device according to claim 7, wherein said logic processing means include at least:

   - a first logic cell receiving, in a first input, each first symbol element a(k), and, in a second input, said envelope logic signal and delivering a first validated symbol element s'(k);
   - a second logic cell receiving, in a first input, each second symbol element b(k), and, in a second input, said envelope logic signal, and delivering a second validated symbol element b'(k).

9. A device according to claim 8, wherein said first and second logic cells are constituted by an identical logic gate, each provided with a first and a second input, the first input of each logic gate constituting the first input of each logic cell and the second input of each logic gate being connected to the second input of each logic cell directly or by means of a logic inverter, as a function of the logic value assigned to the first and second binary value of said envelope logic signal respectively.

10. A device according to claim 7, wherein said discrimination means of said encapsulation message include ;

   - an alignment device enabling, within said encapsulation message, a synchronisation word to be detected ;
   - a circuit for reading within the encapsulation message a message field length;

   an up/down counter loaded from the read value of the message field length and enabling said envelope logic signal to be generated, one of the logic states of which has a length proportional to said message field length read value and packet of encoded symbols length.

$$a(D) = i(D)g_1(D)$$

$$i(D)$$

$$b(D) = i(D)g_2(D)$$

MEMOIRE D'ORDRE n

FIG.1. (ART ANTÉRIEUR)

FIG.2a.

```
                    ┌─────────────┐
                    │  PAQUET Pj  │
                    │   q BITS    │
                    └──────┬──────┘
                           │
                           ▼
            ┌──────────────────────────────┐
            │ FORMATION DANS LE FLUX        │
            │ SÉRIE D'UN MOT DE             │──── a
            │ n = K-1 BITS SUCCESSIFS i(k)  │
            └───────────────┬──────────────┘
                            │
                            ▼
            ┌──────────────────────────────┐
            │ DÉFINITION D'UNE              │
            │ VALEUR BINAIRE STABLE         │──── b
            │ DE DÉPART                     │
            └───────────────┬──────────────┘
                            │
                            ▼
            ┌──────────────────────────────┐
            │ CODAGE CONVOLUTIF DE          │
            │ PROFONDEUR K                  │──── c
            │ S(k) = {a(k); b(k)}           │
            └───────────────┬──────────────┘
                            │
                            ▼
            ┌──────────────────────────────┐
 j = j + 1  │ CONCATÉNATION DES             │
            │ SYMBOLES S(k) ⟹               │──── d
            │ PSj                           │
            └───────────────┬──────────────┘
                            │
                            ▼
            ┌──────────────────────────────┐
            │ IMPOSITION AU CODAGE          │──── e
            │ DE VALEUR BINAIRE STABLE      │
            └───────────────┬──────────────┘
                            │
                            ▼
            ┌──────────────────────────────┐
            │ CRÉATION D'UN MESSAGE         │
            │ Cj D'ENCAPSULATION DE         │──── f
            │ PSj                           │
            └───────────────┬──────────────┘
                            │
                            ▼
            ┌──────────────────────────────┐
            │ TRANSMISSION EN UN MÊME       │──── g
            │ MESSAGE DE Cj + PSj           │
            └───────────────┬──────────────┘
                            │
                            ▼
                    ┌─────────────┐
                    │     FIN     │
                    └─────────────┘
```

$j = j + 1$

# FIG.2b.

# FIG.3a.

PSj    S(k)    Cj

Lj    SYj

1

0  Ej

CK

FIG.3b.

FIG.3c.

| NOEUD | DONNÉE DÉCODÉE | | | | | | | | | | | | | | | | | |
|-------|---|---|---|---|---|---|---|---|---|---|---|---|---|---|---|---|---|---|
| 11 | 0 | 0 | 1 | 1 | 0 | 1 | 0 | 1 | 1 | 1 | 1 | 0 | 1 | 1 | 0 |
| 10 | 0 | 0 | 1 | 1 | 0 | 1 | 1 | 0 | 1 | 0 | 0 | 0 | 1 | 1 | 0 |
| 01 | 0 | 1 | 1 | 1 | 1 | 1 | 1 | 1 | 1 | 0 | 1 | 0 | 0 | 1 | 0 |
| 00 | 0←0←0←0 | 1 | 0 | 1 | 1 | 0 | 0 | 1←0←0←0 | 0 |

☐ PAQUET          PSj          PSj-1

FIG.4a.

PSj  Cj

1

Cj

Ej

PSj

PSj

2

TRAITEMENT
LOGIQUE

S(k)

S'(k)
S r(k)

3

DÉCODEUR
DE
VITERBI

# FIG.4b.

# FIG.4c.

# FIG.4d.

# FIG.4e.

# FIG.5.

# FIG.6.

TEMPS DE TRAITEMENT